# FASCICULE DE BREVET EUROPEEN

(11) **EP 2 691 563 B1**
(45) Date de publication et mention de la délivrance du brevet: **06.05.2015**
(21) Numéro de dépôt: 12717340.9
(22) Date de dépôt: 29.03.2012
(51) Int. Cl.: C23C 16/04, C23C 16/06, C30B 25/18, C30B 29/02, B82Y 30/00, C23C 16/01, C30B 29/60

(54) **RÉSEAU DE NANOTUBES MÉTALLIQUES**
NETZ VON METALLISCHEN NANORÖHREN
ARRAY OF METALLIC NANOTUBES

(30) Priorité: 29.03.2011 FR 1100923
(43) Date de publication de la demande: 05.02.2014
(73) Titulaire: Commissariat à l'Énergie Atomique et aux Énergies Alternatives, 75015 Paris (FR)
(72) Inventeur: LAZAR, Florica, F-69100 Villeurbanne (FR); MORIN, Arnaud, F-38100 Grenoble (FR)
(74) Mandataire: Talbot, Alexandre
(86) Numéro de dépôt international: PCT/FR2012/000118
(87) Numéro de publication internationale: WO 2012/131194

(56) Documents cités:
- US-A1- 2005 056 118
- US-A1- 2007 202 673
- WANG J H ET AL: "Synthesis of Cu nanotubes with silicon oxide nanowire templates by MOCVD", ELECTROCHEMICAL AND SOLID-STATE LETTERS 2005 ELECTROCHEMICAL SOCIETY INC. US, vol. 8, no. 1, 2005, pages C9-C11, XP002666158, DOI: DOI:10.1149/1.1836112

## Description

### Domaine technique de l'invention

L'invention est relative à un procédé de réalisation de réseau ou tapis de nanotubes métalliques, et plus particulièrement de nanotubes en métal noble.

### État de la technique

Les nanotubes métalliques peuvent être utiles dans de nombreuses applications, telles que la conversion d'énergie, la catalyse ou la détection de gaz. Les nanotubes formés de métaux nobles (Pt, Au, Ir, Pd...) sont particulièrement intéressants en raison de leur conductivité électrique élevée, de leur résistance à l'oxydation et de leurs propriétés catalytiques. Par nanotube, on entend une structure ayant la forme d'un cylindre creux dont le diamètre est inférieur à 1 µm.

Une technique classique pour fabriquer des nanotubes métalliques consiste à recouvrir de métal les parois internes d'un support poreux, appelé également matrice. La matrice poreuse est ensuite éliminée pour libérer les nanotubes métalliques. Le métal peut être déposé sur les parois des pores de différentes façons.

La demande de brevet US2006/0289351 décrit un procédé de réalisation de nanotubes en bismuth à partir d'une membrane en oxyde d'aluminium (alumine). La membrane est rendue poreuse à l'aide d'un traitement d'anodisation. Une pluralité de pores longitudinaux, de forme et dimensions identiques, est ainsi créée. La membrane est recouverte d'une couche de bismuth, puis chauffée pour faire fondre le métal. Le bismuth s'introduit dans les pores de la membrane et recouvre les parois pour former des nanotubes. Cette technique de dépôt par mouillage est limitée aux métaux ayant une faible température de fusion.

Dans l'article [« Metal nanotubes prepared by a sol-gel method followed by a hydrogen reduction procédure », Hua et al., Nanotechnology 17, p.5106-5110, 2006], la matrice poreuse est imprégnée d'une pâte (sol) contenant un solvant, un agent de coordination et des sels métalliques. Un traitement thermique est appliqué pour évaporer le solvant, formant ainsi des nanotubes d'oxydes métalliques dans les pores de la matrice. Enfin, une réaction de réduction par l'hydrogène convertit l'oxyde en métal.

L'article [« Electroplating of metal nanotubes and nanowires in a high aspect-ratio nanotemplate », Fu et al., Electrochemistry Communications 10, p.514-518, 2008] décrit le dépôt de platine par électrodéposition. De l'or est pulvérisé sur une membrane poreuse d'alumine de manière à constituer une électrode de travail lors de l'électrodéposition. Le platine se dépose sur l'or, puis le long des parois des pores.

L'utilisation d'une matrice poreuse implique des contraintes dimensionnelles fortes sur les nanotubes. Par exemple, le diamètre des pores cylindriques de la matrice, et donc le diamètre des nanotubes, est difficile à contrôler. En outre, la matrice étant éliminée, les nanotubes obtenus sont individualisés et ne peuvent former un tapis de nanotubes. Enfin, ces procédés sont lourds à mettre en oeuvre et nécessitent d'être adaptés à chaque changement de métal. Il est donc difficile de définir un procédé simple et universel.

Le document « Ferroelectric nanotubes fabricated using nanowires as positive templates » (M. Alexe et al., Applied Physics letters 89, 172907, 2006) décrit une autre technique de formation de nanotubes métalliques. Des nanofils en silicium sont d'abord formés sur un substrat de croissance, puis recouverts de platine et d'un métal ferroélectrique pour former des nanotubes multicouches. Ces métaux sont déposés par pulvérisation magnétron et par laser pulsé (PLD) respectivement.

Le silicium des nanofils est ensuite gravé dans une solution d'hydroxyde de potassium (KOH) pour libérer les nanotubes. Les nanotubes sont ensuite désolidarisés du substrat de croissance, puis transférés un par un sur un autre substrat en silicium recouvert de platine, au moyen d'un nano-manipulateur.

Comme précédemment, cette technique ne permet pas d'obtenir un réseau de nanotubes organisés les uns par rapport aux autres et orientées de la même façon, sous la forme d'un tapis de nanotubes.

### Résumé de l'invention

On constate le besoin d'un procédé de réalisation d'un réseau organisé de nanotubes métalliques, facile à mettre en oeuvre et permettant de relâcher les contraintes dimensionnelles sur les nanotubes.

On tend à satisfaire ce besoin en prévoyant des nanofils en un matériau sacrificiel sur un support, en déposant une couche de métal sur les nanofils de manière à former des nanotubes métalliques concentriques avec les nanofils, en déposant une couche de liaison en matériau polymère sur le support, en éliminant le support, la couche de liaison assurant le maintien des nanotubes métalliques, et en éliminant le matériau sacrificiel.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- les figures 1 à 3 représentent des étapes d'un mode de mise en oeuvre de procédé de réalisation de nanotubes métalliques à partir de nanofils en silicium ;
- les figures 4 et 5 représentent des étapes supplémentaires du procédé de réalisation de nanotubes métalliques, respectivement le dépôt d'une couche de polymère et le retrait du substrat de croissance des nanofls ;
- la figure 6 représente une variante de mise en oeuvre de l'étape de dépôt de la couche polymère de la figure 4 ; et
- la figure 7 représente un tapis de nanotubes métalliques obtenu par le procédé des figures 1 à 6.

### Description d'un mode de réalisation préféré de l'invention

Plutôt que d'imprégner de métal les pores cylindriques d'une matrice, on forme des nanotubes métalliques en déposant le métal sur des nanofils en matériau sacrificiel. Les nanofils, servant de modèle, définissent ainsi la disposition et les dimensions des nanotubes. Le matériau sacrificiel est ensuite gravé pour former la cavité intérieure des nanotubes.

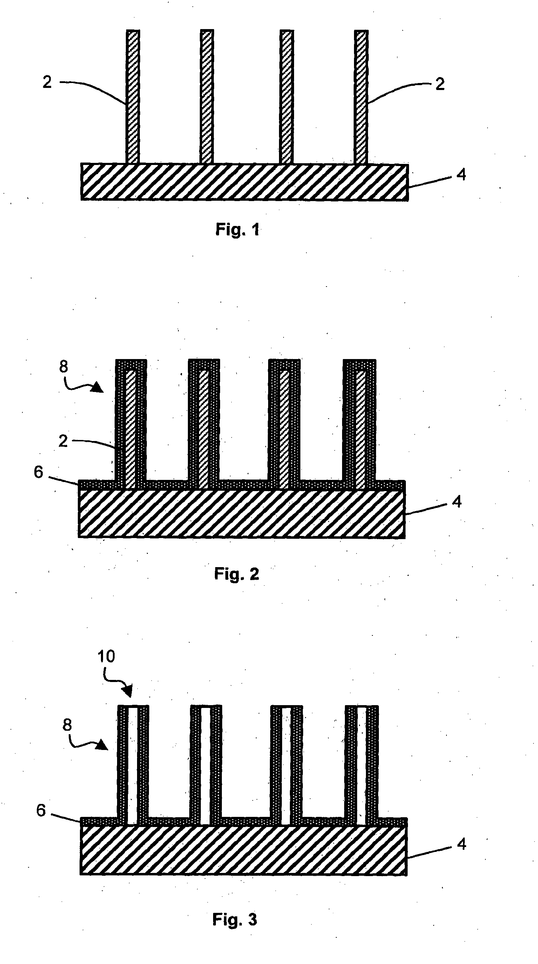

Les figures 1 à 3 représentent des étapes génériques d'un procédé de réalisation de nanotubes métalliques.

A la figure 1, des nanofils de silicium 2 sont formés sur un substrat 4. Les nanofils 2 sont, de préférence, formés par la technique de croissance VLS (vapeur-liquide-solide). Cette technique consiste à amener le silicium sous forme gazeuse (silane) au voisinage d'un catalyseur liquide disposé sur le substrat de croissance sous forme de gouttes (colloïdes d'or par exemple). Le silicium précipite alors en phase solide en contact avec le catalyseur pour former des nanofils de diamètre égal à celui des gouttes. Alternativement, les nanofils de silicium peuvent être formés par une gravure anisotrope d'un substrat de silicium ou par un dépôt chimique en phase vapeur (CVD).

Les nanofils ont un diamètre compris entre 10 nm et 50 µm, de préférence entre 100 nm et 1 µm. La longueur des nanofils varie entre 5,5 µm et 30 µm. Le support de croissance 4 peut être constitué de silicium, de métal, de verre ou tout autre matériau adapté à la croissance des nanofils par la technique VLS.

La figure 2 représente le dépôt d'une couche de métal 6 sur les nanofils 2 et, de façon optionnelle, sur le substrat de croissance 4. La couche 6 est, de préférence, déposée de manière conforme afin de reproduire la forme des nanofils. On forme ainsi des tubes métalliques 8, chaque tube comprenant un nanofil 2 en son centre.

La couche 6 peut être déposée par voie chimique, et plus particulièrement par dépôt chimique en phase vapeur à partir de précurseurs organométalliques (MOCVD, « Metal-Organic Chemical Vapor Deposition »). Grâce à cette technique, le dépôt est constitué de nanoparticules de métal agglomérées et présente un aspect poreux. Dans un dispositif de type catalyseur ou réacteur électrochimique, cette couche poreuse permet une meilleure utilisation du métal car la surface de contact avec les réactifs est augmentée.

Le dépôt de la couche 6 peut également être réalisé par une technique de dépôt CVD hybride appelée dépôt de couches atomiques (ALD, « Atomic Layer Déposition ») qui permet d'obtenir des dépôts conformes et denses, par évaporation (canon à effet Joule, e-beam...) ou par pulvérisation cathodique. La couche de métal 6 est alors continue et recouvre tout le substrat. Le dépôt peut également être réalisé par réduction chimique d'un sel métallique. Lorsque les nanofils 2 sont en matériau semi-conducteur dopé, ils ont un comportement métallique et la couche 6 peut être formée par électrodéposition.

L'épaisseur de la couche 6 est, de préférence, comprise entre 2 nm et 20 nm, ce qui correspond à l'épaisseur des parois des nanotubes 8. Le métal est, de préférence, choisi parmi les métaux nobles (platine, or, argent, iridium, palladium...) ou leurs alliages.

L'étape de la figure 3 correspond à l'élimination par gravure chimique des nanofils de silicium. Préalablement, les tubes 8, c'est-à-dire les nanofils recouverts de la couche 6, peuvent être ouverts à au moins une extrémité. Sur l'exemple de la figure 3, la solution de gravure accède au silicium après ouverture des extrémités libres 10 des tubes, c'est-à-dire des extrémités opposées au substrat. Cette ouverture est de préférence réalisée par polissage mécano-chimique, ce qui permet d'égaliser la longueur de tous les nanotubes.

La solution de gravure peut également accéder au silicium en traversant les parois des nanotubes 8 lorsque celles-ci sont poreuses. L'étape d'ouverture des extrémités est alors optionnelle.

Dans le cas du silicium, la solution de gravure comprend classiquement de l'hydroxyde de potassium (KOH), un mélange d'acide fluorhydrique (HF), d'acide nitrique (HNO₃) et d'acide acétique (CH3COOH), un mélange d'HF et de fluorure d'ammonium (NH₄F) ou de l'hydroxyde de tétraméthylammonium (TMAH).

Pour réaliser cette gravure, il est préférable de verser la solution chimique sur le substrat des nanofils goutte après goutte, au lieu de plonger le substrat dans un bain de gravure. En outre, la solution est portée à une température proche de celle du substrat. On évite ainsi les chocs thermiques, néfastes pour les nanotubes. La solution et le substrat sont, par exemple, chauffés à une température comprise entre 35 °C et 60 °C.

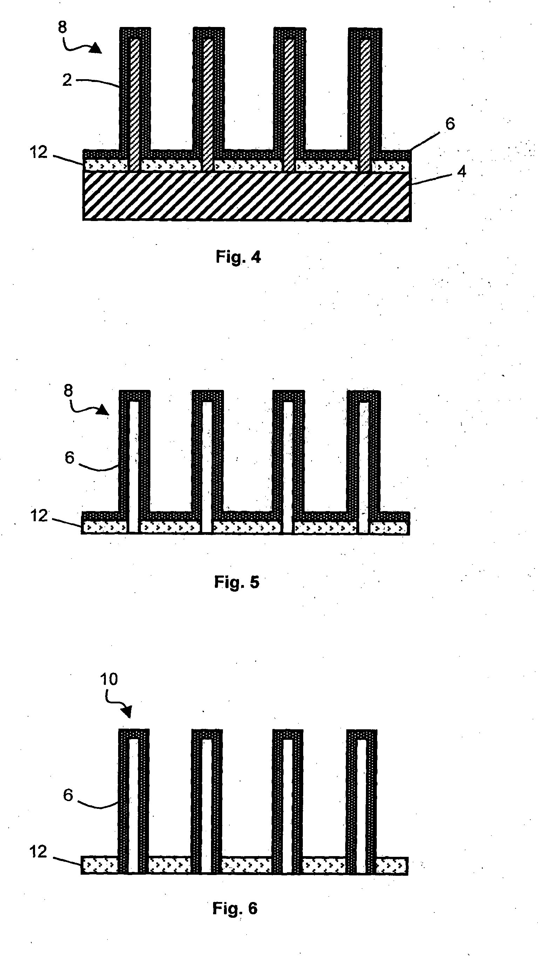

Les figures 4 et 5 représentent des étapes d'une variante de mise en oeuvre du procédé, dans laquelle une couche de liaison, par exemple en polymère ou céramique, constitue le support mécanique entre les nanotubes, à la place du support de croissance.

A la figure 4, on dépose une couche 12 sur le support de croissance 4, avant le dépôt de la couche de métal 6 (Fig.2). L'épaisseur de la couche 12 est, de préférence, inférieure à celle des nanofils 2, entre 5 µm et 25 µm.

Le matériau de la couche 12 est choisi parmi des matériaux résistants à l'étape de gravure des nanofils et au procédé de dépôt métallique, notamment à la température de dépôt par MOCVD. Par matériau résistant, on entend un matériau qui conserve son intégrité, c'est-à-dire sa structure chimique et physique sans perte ou gain de matière, après une étape technologique.

Dans le cas d'un matériau céramique, le matériau 12 peut être de l'alumine ou un verre.

Dans le cas d'un polymère, le matériau 12 est, par exemple, choisi parmi les polyamides, les polymères fluorés (PVDF, HFP), les polymères perfluorés (PTFE), les polymères perfluorosulfonés (Nafion®, Aquivion™), le polyvinylpyrrolidone (PVP), les polyimides (Kapton), les polyaryléthers cétone, les polyaryléthersulfones, les polybenzimidazoles et leurs copolymères.

La couche 12 en polymère est, de préférence, déposée à la tournette (« Spin-coating »). On peut aussi envisager de déposer un polymère en solution dans un ou plusieurs solvants, puis d'effectuer un traitement thermique pour évaporer les solvants.

Plusieurs modes de mise en oeuvre de la couche polymère 12 sont décrits ci-après, dans les cas préférentiels de polymères fluorés, perfluorés et perfluorosulfonés.

Les polymères fluorés sont des polymères contenant dans leur motif de répétition, ou unité monomère, au moins un groupement C-F. On peut notamment utiliser le polyfluorure de vinylidène (PVDF) ou le polyfluorure de vinylidène-co-hexafluoropropène (PVDF-HFP). La couche 12 est réalisée à partir de ces polymères en solution dans un ou plusieurs solvants choisis parmi le diméthylacétamide (DMAc), le diméthylformamide (DMF), le diméthylsulfoxyde (DMSO) et le N-méthylpyrollidone (NMP). Les solvants sont ensuite évaporés par traitement thermique.

Avec ce type de polymères, il convient de prendre des précautions quant aux gravures ultérieures du support et du matériau sacrificiel. En effet, comme les unités monomères de type VDF sont sensibles aux bases, il est préférable d'utiliser des solutions d'attaque acides.

Les polymères perfluorés sont des polymères ne contenant pas de groupements C-H dans leur motif de répétition mais une majorité de groupements C-F2. Le polytétrafluoroéthylène, ou PTFE, est le plus répandu dans cette catégorie. On pourra également utiliser des polymères issus de monomères contenant des groupements de type tétarfluoroéthylène (TFE), hexafluoropropène (HFP), perfluoroalcoxy (PFA), chlorotrifluoroéthylène (CTFE), et leurs copolymères. Ces polymères sont résistants aux acides et aux bases.

A l'inverse des polymères fluorés, les polymères perfluorés ne sont pas solubles. Pour être mis en forme, les monomères sont polymérisés en suspension, à l'instar du PTFE, ou en voie fondue. La mise en oeuvre à partir d'une solution de suspension est toutefois délicate dans la mesure où elle est très liquide. Par la suite, on réalise une étape de frittage à une température comprise entre 120 °C et 200 °C.

Les polymères perfluorosulfonés présentent l'avantage d'être disponibles en suspension dans un mélange d'eau et d'alcool, voire en suspension aqueuse (eau uniquement). On utilise, de préférence, une solution contenant entre 4 % et 25 % en masse de monomère dans la suspension. Pour la réalisation de la couche polymère, il est avantageux d'ajouter à la solution de suspension eau/alcool initiale une proportion de solvant de type DMF, DMAc ou DMSO égale au volume de polymère. L'utilisation de ces solvants facilite la mise en forme et permet d'obtenir une couche avec de meilleures propriétés mécaniques. Par ailleurs, il est également avantageux d'échanger l'ionomère (qui se présente sous forme protonée) avec un contre-ion de type Na⁺, Li⁺, voire un ion de divalent (Cu²⁺) après le retrait du support. Ce type d'ion permet d'améliorer la stabilité mécanique du ionomère.

Lés polymères fluorés, perfluorés et perfluorosulfonés sont préférés car ils sont stables vis-vis de la réaction d'oxydation qui a lieu lors de l'étape d'élimination du matériau sacrificiel et de l'étape de gravure du support, décrite ci-dessous en relation avec la figure 5.

L'accès pour la gravure du silicium des nanofils peut être réalisé en éliminant la partie supérieure de la couche 6, comme cela a été décrit en relation avec la figure 3. Or, la couche 12 assure le maintien des nanotubes. Il est donc possible de réaliser cet accès de l'autre côté des nanofils, en retirant le substrat de croissance 4.

La figure 5 représente l'étape de retrait du support de croissance. Ce retrait peut être réalisé par gravure ou par polissage mécano-chimique en fonction de la nature du substrat et de son épaisseur, avant la gravure des nanofils. Dans le cas d'un substrat en silicium, le retrait du substrat est, de préférence, réalisé en même temps que l'élimination des nanofils.

La figure 6 représente une variante de réalisation de l'étape de la figure 4. La couche 12 est déposée après le dépôt de métal 6. Ce dépôt de métal 6 peut d'ailleurs être localisé sur les nanofils 2 uniquement, par électrodéposition ou l'ablation laser pulsée.

Dans une autre variante de réalisation (non représentée), le dépôt de la couche 12 est précédé du dépôt d'une couche additionnelle de métal. Cette couche additionnelle participe alors au maintien des nanotubes métalliques 6, en association avec la couche polymère ou céramique 12.

Dans ces modes de réalisation, les nanofils de silicium 2 sont, de préférence, de dimensions identiques et de même orientation, de manière à former un ensemble homogène de nanotubes. Les nanotubes sont solidarisés, soit par le support de croissance 4 (Fig.3), soit par la couche 12 (Fig.5-7). Cet ensemble est généralement appelé tapis de nanotubes ou réseau de nanotubes. Ce tapis peut être intégré dans des dispositifs tels que les détecteurs de gaz, les dispositifs de conversion et de stockage de l'énergie, les filtres à particules et les membranes de purification de l'eau.

Contrairement aux techniques classiques, ce procédé permet la formation d'une pluralité de nanotubes dont les dimensions et la répartition sont maîtrisées. Ce contrôle est rendu possible par la formation d'un modèle constitué de nanofils en matériau sacrificiel. La distance entre les nanotubes dépend de la distance entre les nanofils et de l'épaisseur de la couche métallique. Le diamètre intérieur des nanotubes est fixé par le diamètre des nanofils. La longueur des nanotubes dépend principalement de la longueur des nanofils, et dans le mode de réalisation des figures 4 et 5, de l'épaisseur de la couche 12.

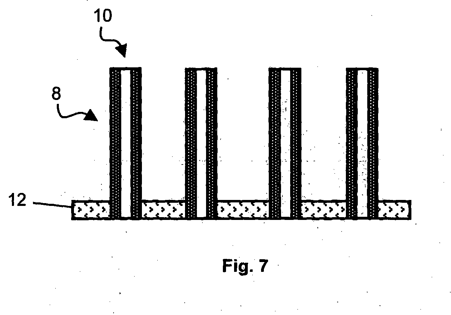

La figure 7 représente un tapis de nanotubes 8 muni d'une couche polymère 12. Les nanotubes sont, de préférence, espacés d'une distance supérieure à 50 nm. Les nanotubes sont ouverts des deux côtés, suite au polissage des extrémités libres 10 des nanotubes 8 puis au retrait du substrat. Ils constituent alors des canaux de circulation. A titre d'exemple, ils peuvent servir au transport de gaz ou de fluide au sein d'un capteur de gaz ou d'un filtre à particules.

Grâce aux propriétés mécaniques des polymères, le tapis de nanotubes peut être souple. L'épaisseur et la disposition de la couche polymère (ou céramique) 12 conditionnent en fait la rigidité du tapis. Il est possible de faire varier la position de la couche 12, par exemple en prévoyant un matériau sacrificiel additionnel sur le substrat avant le dépôt du polymère ou en gravant la partie inférieure de cette couche, après avoir retiré le substrat.

Les tapis de nanotubes représentés aux figures 3, 5 à 7 sont particulièrement bien adaptés aux applications nécessitant une grande surface métallique, comme les catalyseurs ou les cellules électrochimiques (piles à combustible, batteries métal-air...). En effet, le rapport de la surface de métal sur le volume est élevé, ce qui augmente les performances de ces dispositifs pour une même quantité de métal.

De nombreuses variantes et modifications du procédé de réalisation de nanotubes métalliques décrit ici apparaîtront à l'homme du métier. Bien que le procédé ait été décrit en relation avec des nanofils en silicium, on pourra utiliser d'autres matériaux sacrificiels, notamment des nanofils de cuivre, d'oxyde de zinc (ZnO) ou d'oxyde de titane (TiO₂).

On pourra également envisager des nanotubes en matériau sacrificiel, en carbone par exemple, comme modèle au lieu des nanofils, et plus généralement des nanoéléménts longilignes à rapport hauteur sur largeur élevé. On obtiendra alors un tapis de nanotubes de carbone métallisés, c'est-à-dire des nanotubes métalliques concentriques avec les nanotubes de carbone, avant d'éliminer le carbone. On peut aussi envisager d'éliminer le matériau sacrificiel avant le support.

## Revendications

1. Procédé de réalisation d'un réseau de nanotubes métalliques comprenant les étapes suivantes :
- prévoir des nanofils (2) en un matériau sacrificiel sur un support (4) ;
- déposer une couche de métal (6) sur les nanofils de manière à former des nanotubes métalliques (8) concentriques avec les nanofils ;
- éliminer le matériau sacrificiel ;
**caractérisé en ce qu'**il comporte les étapes suivantes :
- déposer une couche de liaison (12) en matériau polymère entre les nanofils (2) ; et
- éliminer le support, la couche de liaison assurant le maintien des nanotubes métalliques.

2. Procédé selon la revendication 1, dans lequel le matériau polymère (12) est choisi parmi les polymères fluorés, les polymères perfluorés, les polymères perfluorosulfonés et leurs copolymères.

3. Procédé selon la revendication 1 ou 2, dans lequel la couche de liaison (12) est déposée sur une hauteur inférieure à celle des nanofils (2).

4. Procédé selon l'une quelconque des revendications 1 à 3, comprenant, après l'étape de dépôt de la couche de métal (6), une étape d'ouverture des nanotubes métalliques (8) aux extrémités libres (10) des nanolubes.

5. Procédé selon l'une quelconque des revendications 1 à 4, dans lequel le support (4) et le matériau sacrificiel (2) sont éliminés simultanément.

6. Procédé selon l'une quelconque des revendications 1 à 5, dans lequel le dépôt de la couche de métal (6) est réalisé par MOCVD.

7. Procédé selon l'une quelconque des revendications 1 à 6, dans lequel le métal (6) est choisi parmi les métaux nobles et leurs alliages.

8. Procédé de réalisation d'un réseau de nanotubes métalliques comprenant les étapes suivantes :
- prévoir des nanotubes (2) en un matériau sacrificiel sur un support (4) ;
- déposer une couche de métal (6) sur les nanotubes en matériau sacrificiel de manière à former des nanotubes métalliques (8) concentriques avec les nanotubes en matériau sacrificiel ;
- déposer une couche de liaison (12) en matériau polymère entre les nanotubes (2) ;
- éliminer le support, la couche de liaison assurant le maintien des nanotubes métalliques ; et
- éliminer le matériau sacrificiel.

## Patentansprüche

1. Verfahren zur Ausbildung eines Netzes von metallischen Nanoröhren, umfassend die folgenden Schritte:
- Vorsehen von Nanodrähten (2) aus einem Opfermaterial auf einem Träger (4);
- Abscheiden einer Metallschicht (6) auf den Nanodrähten, um mit den Nanodrähten konzentrische metallische Nanoröhren (8) zu bilden;
- Entfernen des Opfermaterials;
**dadurch gekennzeichnet, dass** es die folgenden Schritte umfasst:
- Abscheiden einer Verbindungsschicht (12) aus Polymermaterial zwischen den Nanodrähten (2); und
- Entfernen des Trägers, wobei die Verbindungsschicht den Halt der metallischen Nanoröhren sicherstellt.

2. Verfahren nach Anspruch 1, wobei das Polymermaterial (12) aus den Fluorpolymeren, den Perfluor-Polymeren, den Perfluorsulfon-Polymeren und ihren Copolymeren ausgewählt ist.

3. Verfahren nach Anspruch 1 oder 2, wobei die Verbindungsschicht (12) über eine Höhe, die geringer als diejenige der Nanodrähte (2) ist, abgeschieden wird.

4. Verfahren nach einem der Ansprüche 1 bis 3, das nach dem Schritt des Abscheidens der Metallschicht (6) einen Schritt zum Öffnen der metallischen Nanoröhren (8) an den freien Enden (10) der Nanoröhren umfasst.

5. Verfahren nach einem der Ansprüche 1 bis 4, wobei der Träger (4) und das Opfermaterial (2) gleichzeitig entfernt werden.

6. Verfahren nach einem der Ansprüche 1 bis 5, wobei die Abscheidung der Metallschicht (6) durch MOCVD vollzogen wird.

7. Verfahren nach einem der Ansprüche 1 bis 6, wobei das Metall (6) aus den Edelmetallen und ihren Legierungen ausgewählt ist.

8. Verfahren zur Ausbildung eines Netzes von metallischen Nanoröhren, umfassend die folgenden Schritte:
- Vorsehen von Nanoröhren (2) aus einem Opfermaterial auf einem Träger (4);
- Abscheiden einer Metallschicht (6) auf den Nanoröhren aus Opfermaterial, um mit den Nanoröhren aus Opfermaterial konzentrische metallische Nanoröhren (8) zu bilden;
- Abscheiden einer Verbindungsschicht (12) aus Polymermaterial zwischen den Nanoröhren (2);
- Entfernen des Trägers, wobei die Verbindungsschicht den Halt der metallischen Nanoröhren sicherstellt; und
- Entfernen des Opfermaterials.

## Claims

1. Method for producing an array of metallic nanotubes comprising the following steps:
- providing nanowires (2) made from sacrificial material on a support (4);
- depositing a metal layer (6) on the nanowires so as to form metallic nanotubes (8) concentric with the nanowires;
- eliminating the sacrificial material;
**characterized in that** it comprises the following steps:
- depositing a binding layer (12) made from polymer material between the nanowires (2); and
- eliminating the support, the binding layer supporting the metallic nanotubes.

2. Method according to claim 1, wherein the polymer material (12) is chosen from fluorinated polymers, perfluorinated polymers, perfluoro-sulfonated polymers and their copolymers.

3. Method according to claim 1 or 2, wherein the binding layer (12) is deposited over a height lower than that of the nanowires (2).

4. Method according to any one of claims 1 to 3, comprising, after the step of depositing the metal layer (6), a step of opening the metallic nanotubes (8) at the free ends (10) of the nanotubes.

5. Method according to any one of claims 1 to 4, wherein the support (4) and the sacrificial material (2) are eliminated simultaneously.

6. Method according to any one of claims 1 to 5, wherein depositing the metal layer (6) is performed by MOCVD.

7. Method according to any one of claims 1 to 6, wherein the metal (6) is chosen from noble metals and their alloys.

8. Method for producing an array of metallic nanotubes comprising the following steps:
- providing nanotubes (2) made from sacrificial material on a support (4);
- depositing a metal layer (6) on the sacrificial material nanotubes so as to form metallic nanotubes (8) concentric with the sacrificial material nanotubes;
- depositing a binding layer (12) made from polymer material between the nanowires (2);
- eliminating the support, the binding layer performing support of the metallic nanotubes; and
- eliminating the sacrificial material.
